(19) Europäisches Patentamt
European Patent Office
Office européen des brevets

(11) **EP 4 443 185 A1**

(12) **EUROPEAN PATENT APPLICATION**

(43) Date of publication:
**09.10.2024  Bulletin 2024/41**

(21) Application number: **23166468.1**

(22) Date of filing: **04.04.2023**

(51) International Patent Classification (IPC):
**G01R 33/56** $^{(2006.01)}$     **G01R 33/44** $^{(2006.01)}$
**G01R 33/50** $^{(2006.01)}$

(52) Cooperative Patent Classification (CPC):
**G01R 33/50; G01R 33/448; G01R 33/5608**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
• **Siemens Healthineers AG**
  **91301 Forchheim (DE)**
• **Centre Hospitalier Universitaire Vaudois**
  **1011 Lausanne (CH)**

(72) Inventors:
• **Hilbert, Tom**
  **1006 Lausanne (CH)**
• **Kober, Tobias**
  **1007 Lausanne (CH)**
• **Piredda, Gian Franco**
  **1006 Lausanne (CH)**
• **Ravano, Veronica**
  **1009 Pully (CH)**

(74) Representative: **Fischer, Michael**
  **Siemens AG**
  **Postfach 22 16 34**
  **80506 München (DE)**

(54) **METHOD AND SYSTEM FOR IMPROVED VISUALIZATION OF TISSUE ALTERATION IN MAGNETIC RESONANCE IMAGING**

(57)     The present invention concerns a system and a method for detecting and quantifying a tissue alteration of a biological object, the method comprising:
- acquiring (201) multiple quantitative maps of said biological object, wherein each of said multiple quantitative maps is a quantitative map of a different physical tissue property of said biological object;
- combining (202) the acquired quantitative maps into a "combined quantitative map" (hereafter "CQM");
- calculating (203) a deviation map by comparing the CQM to a normative atlas configured for providing expected values for the CQM.

```
201 → 202 → 203
```

FIG 2

**Description**

The present invention is directed, in general, to imaging techniques for imaging biological objects, like tissues, using Magnetic Resonance Imaging (MRI). More specifically, the present invention is directed to a method and a system for improved visualization and quantification of tissue alteration in MRI.

In recent years, quantitative MRI (qMRI), i.e. the measurement of quantitative, physics-based parameters opposed to relative image contrasts as in conventional MRI, showed to be able to detect microstructural tissue change in response to pathology and/or treatment, and to bring valuable complementary information to standard radiological metrics. To evaluate the extent of tissue alteration, normative atlases can be established from healthy subjects and used for comparison when assessing a patient' health state. This can be compared with a blood test, where a specific parameter is evaluated and compared to a normal range; in qMRI, this comparison is done voxel-wise or for a certain region with respect to a physical parameter measured using the magnetic resonance (MR) phenomenon (e.g., T1 relaxation parameter, tissue fat content, susceptibility, etc.). From normative atlases, deviation maps can be extracted for individual patients, reflecting the extent of microstructural tissue alteration with respect to normal values [1, 2] - i.e., these deviation maps also give a notion of "how far from normal" the parameter is at a specific location in the human body. The use of such advanced sequences in clinical settings allows better and more sensitive disease characterization, hence possibly improving patient diagnosis and prognosis as well as facilitating treatment monitoring. For example, in multiple sclerosis, the evaluation of T1 deviation maps in concentric periventricular rings was shown to correlate better with clinical scores compared to lesion count and volume [3]. Similarly, the estimation of microstructural damage in terms of T1 alteration in white matter tracts was shown to correlate more strongly with disability compared to tract-specific lesion load [4].

However, each qMRI measure is typically sensitive to several physical mechanisms (e.g., presence of iron, water, diffusivity of water molecules...) that in turn reflects different pathological mechanisms (e.g., edema, inflammation, axonal loss, calcification...). For instance, T1 relaxation time is known to not only be sensitive to the presence of myelin in brain and spinal cord, but also to axonal loss [5], both being typical pathological manifestations in multiple sclerosis. This means that different microstructural processes can have the same effect on quantitative measures, limiting then a clear identification of the underlying processes which caused these changes. Additionally, multiple biological processes can occur simultaneously, sometimes neutralizing their measurable impact on the quantitative measures.

To consider said several mechanisms, solutions based on a combination of information from multiple imaging contrasts have been proposed. In particular, multiparametric models that take multiple parametric maps and/or image contrasts as input to predict a target output (e.g., a clinical outcome or a segmentation) have been developed. For instance, Bonnier et al. [6] studied T1, T2 and T2* relaxometry as well as Magnetization Transfer Ratio (MTR) maps combined in multiple sclerosis patients using multivariate linear regression to assess correlation with clinical scores. Deep neural network models have also been used for integrating information from multiple maps and improving the output prediction. However, said solutions are only able to provide aggregated values per patient within a certain region of interest, failing therefore to provide any exact spatial (local, i.e. voxel-wise) representation of said values. Other solutions propose to combine T1- and T2-weighted images. However, such combination suffers from a poor inter-subject comparability as being based on non-quantitative data.

There is thus still a need for improving the detection and quantification of brain tissue pathologies, notably when several physical mechanisms are involved and limit an unambiguous identification of underlying biological mechanisms.

It is therefore an objective of the present invention to provide a method and a system for improved visualization and quantification of physical properties of a tissue of a biological object, enabling for instance to visualize a tissue alteration or pathology, notably in the framework of MRI. This objective is achieved by the measures taken in accordance with the independent claims. Further advantageous embodiments are proposed by the dependent claims.

More precisely, the present invention proposes in particular to use a simultaneous evaluation of several quantitative MRI measures for disentangling sources of tissue alterations. In particular, the present invention proposes to measure, for a region of interest, several distinct qMRI values, and to simultaneously the alterations in each metric associated to said qMRI values in a quantitative and interpretable single map to better disentangle which pathological mechanism is causing the observed effect on a given qMRI map.

The present invention concerns in particular a method for detecting and quantifying, notably in MR images, an abnormal condition or state of a tissue of a biological object, said abnormal condition being for instance a tissue alteration or pathology or under/over development notably with respect to the biological object age, wherein said biological object is in particular a brain of a patient, the method being preferentially implemented by a MR imaging apparatus, and comprising the following steps:

- Step A: acquiring multiple quantitative maps, e.g. qMRI maps, of said biological object, notably by means of said MR imaging apparatus, wherein each of said multiple quantitative maps is a quantitative map of a different physical tissue property of said biological object. In other words, each quantitative map according to the invention provides a voxel-wise measure of a single physical tissue property of said biological object, each quantitative map mapping a different physical property for a same tissue of said biological object. This means that for a set $M=\{M_1,...,M_n\}$ of a number n of quantitative maps according to the invention that are configured for mapping a same part or region of the biological object, and thus the same tissue(s), with $n\geq2$, each quantitative map $M_i$ is configured for mapping a physical tissue property $P_i$ of the tissue(s) of said part, wherein $\forall i,j \in \{1, ..., n\}$, $P_i \neq P_j$ if $i\neq j$, and wherein each voxel value of the quantitative map $M_i$ represents or is a direct measurement of the biological object physical tissue property $P_i$, such as T1 or T2 relaxation times, or proton density (PD), measured at a specific location within said part of the biological object. For instance, a first map $M_1$ might be a T1 map and a second map $M_2$ might be a T2 map of said biological object, each of said T1 and T2 maps being a qMRI map of the biological object representing, each, values of a different physical tissue property measured for said biological object;

- Step B: combining, e.g. by means of a combination algorithm, the acquired quantitative maps into a "combined quantitative map" (hereafter "CQM"), wherein said combination is preferably an algebraic operation (e.g. division, subtraction, etc.) performed on said acquired quantitative maps, the result of said algebraic combination being said CQM. Said combination is typically performed voxel-wise or region-wise: for instance, the value of a voxel $V_i$ of the quantitative map $M_i$ is combined to the value of a voxel $V_j$ of the quantitative map $M_j$, wherein $V_i$ and $V_j$ are located at the same specific location within said biological object, said combination being performed for all voxels of the maps $M_i$ and $M_j$; similarly, for the region-wise combination, a mean value $V_{a,i}$ calculated from the values of all voxels $V_i$ belonging to a region of said biological object in the quantitative map $M_i$ is combined to a mean value $V_{a,j}$ calculated from the values of all voxels $V_j$ belonging to the same region in the quantitative map $M_j$. Said combination according to the invention might be preceded and/or followed by a transformation, e.g. a Fourier transform, or a spatial registration, or any other known in the art transformation. Said transformation might be configured for instance for spatially registering the quantitative maps to be combined;

- Step C: calculating or computing a deviation map by comparing the CQM to a normative atlas configured for providing expected values for the CQM (i.e. normative values for said biological object). Said normative atlas is in other words a CQM of reference or "reference CQM". Said normative atlas is for instance obtained by performing step A and step B for a group of normative biological objects (i.e. healthy biological objects), e.g. for a group of healthy individuals (healthy cohort), obtaining for each biological object of said group, for instance for each individual of said healthy cohort, a "normative" CQM, i.e. a CQM that characterizes said biological object when its tissues are characterized by physical tissue properties that are within the norm or standard when considering healthy biological objects, for instance when said tissues are free of any alteration or pathology, wherein all normative CQMs of said group are then combined (e.g. mathematically combined according to a mathematical model, for instance by calculating average values for each voxel or region of the obtained normative CQMs) in order to generate said reference CQM, i.e. said normative atlas. The normative atlas provides thus expected values for healthy biological objects when considering a combination of physical tissue properties obtained for instance via said combination algorithm. A (voxel-wise or region-wise) value of the CQM that deviates from such an expected value might be then considered as an abnormal value, being the sign of an abnormal condition or state of the tissue under investigation, resulting for instance from a tissue alteration or tissue pathology or a health problem of the biological object under investigation. Preferentially, said deviation map is computed as a z-score map, wherein a difference between a measured value (i.e. a voxel value, or respectively a regional value) obtained for a first specific location within the CQM and an expected value (i.e. a voxel value, or respectively a regional value) obtained for a corresponding specific location within the normative atlas is divided by the root mean square error (RMSE) of residues of the mathematical model used for creating said normative atlas. Each voxel intensity of the deviation map represents thus a deviation of the value of said voxel in the CQM from the value of said voxel provided by the normative atlas.

The present invention concerns also a system for improved visualization and quantification of an abnormal condition or state of a tissue of a biological object, e.g. for detecting and quantifying a tissue alteration of said biological object , wherein said system might comprise or be connected to an imaging apparatus, e.g., an MRI apparatus, for acquiring quantitative maps, e.g., qMRI maps, of the biological object, said system comprising for instance, an interface, a processor, a memory, and being configured for performing the method steps previously described. Preferentially, each step of the method is automatically performed, in a manner free of human intervention.

The claimed invention will be now best understood from the following detailed description of specific embodiments when read in connection with the accompanying drawings, wherein like numbers designate like objects, and in which:

Figure 1    is a schematic illustration of a system according to the invention;

Figure 2    illustrates a flowchart of a method according to the invention;

Figure 3    shows a deviation map obtained by comparing a CQM to a normative atlas;

Figure 4    illustrates the creation of a CQM;

Figure 5    illustrates the creation of a normative atlas.

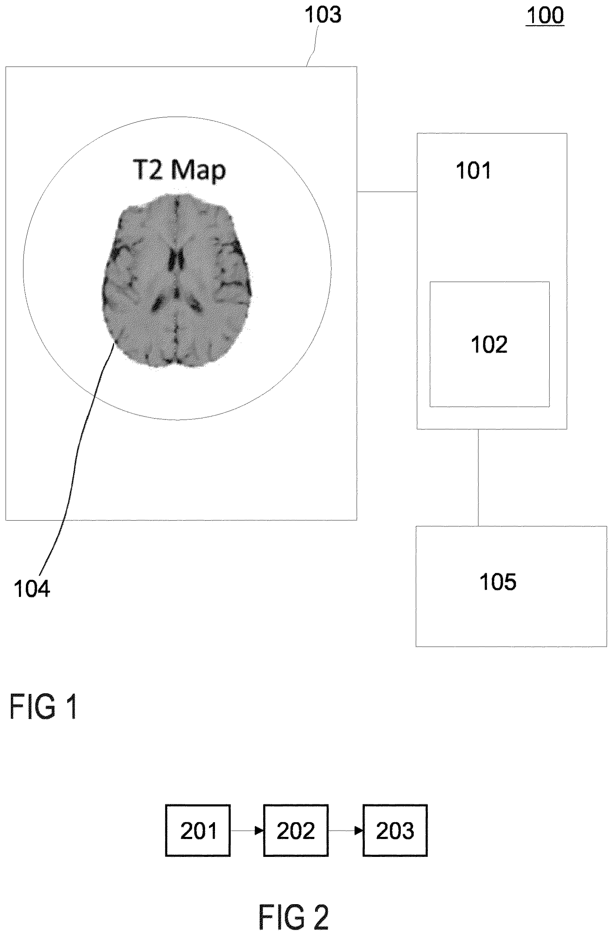

Figure 1 illustrates a preferred embodiment of a system 100 according to the invention. Said system 100 comprises a processing unit 101 comprising a processor and a memory 102, the processing unit 101 being configured for processing images acquired by an imaging apparatus, e.g. an MRI apparatus 103, wherein said imaging apparatus is configured for acquiring quantitative maps, e.g. qMRI maps 104, e.g. a T2 map, of a biological object under examination (also called hereafter the "examined" biological object or "EBO"), e.g. a human brain. The MRI apparatus 103 might be part or not of the system 100 according to the invention. In particular, it can be connected to the processing unit 101 via an interface (not shown), feeding the latter with qMRI maps, the processing unit 101 being then preferentially configured for processing said qMRI maps according to the claimed method. Preferentially, the system 100 further comprises a display 105, preferentially configured for displaying the deviation map according to the invention.

Contrary to prior art systems for visualizing tissue alteration, the system 100 according to the invention is configured for carrying out the following method described in connection with Figures 2 to 5.

It has to be noted that while the concrete examples provided herewith focus on the use of MR-based imaging/parametric mapping, the concept of the present invention applies mutatis mutandis to quantitative maps obtained via other imaging techniques. Indeed, while the described preferred embodiments are based on an acquisition of qMRI maps acquired by an MRI apparatus, said embodiments might be generalized to any acquisition of quantitative maps acquired by an imaging apparatus configured for imaging a biological object.

At step "A" 201, the system 100 acquires or receives a plurality of qMRI maps for the EBO, e.g. a human brain of a patient. Said plurality of qMRI maps might be directly acquired from the MRI apparatus 103 or might be uploaded in the memory 102 of the system 100 from another memory device, or by any other means enabling the system 100 to receive said plurality of qMRI maps. Preferentially, the acquired qMRI maps are saved in the memory 102 of the system 100.

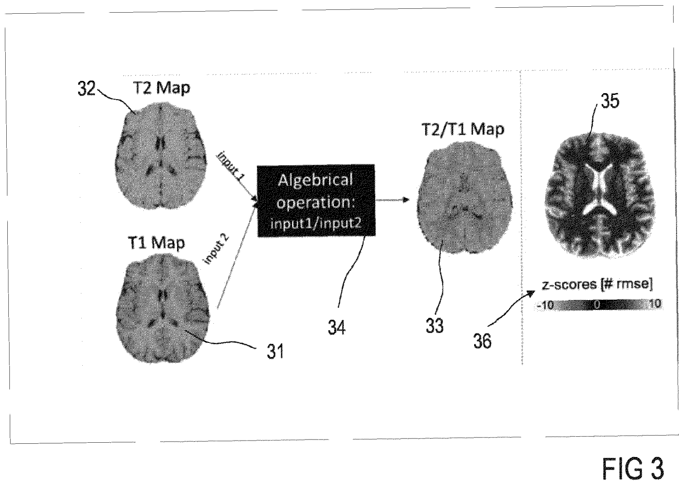

As explained earlier, each voxel intensity or value of a qMRI map according to the invention represents or is a measure of a physical tissue property carried out at a specific location within or on said EBO, each voxel corresponding to a different specific location within or on said EBO (i.e. two different voxels of the qMRI map correspond respectively to two different specific locations within or on the EBO). According to the present invention, each qMRI map is a measure of a different physical tissue property for said EBO (i.e. they are maps of the same object, but represent each a different physical tissue property), so that there are as many different physical tissue properties that have been measured or probed as the number of said qMRI maps that will be combined for creating the CQM as explained afterwards. Figure 3 provides for instance an example wherein a first qMRI map 31 is a T1 map, and a second qMRI map 32 is a T2 map acquired for a human brain as EBO. Preferentially, at least two qMRI maps are acquired, each of the acquired qMRI maps being one of the maps of the following list: a T1 quantitative map, or a T2 quantitative map, or a T2* quantitative map, or a diffusion coefficient map, or a myelin concentration map, or any microstructural map, and wherein each of the acquired qMRI maps is a map of a different physical tissue property of the biological object with respect to any other qMRI map that has been acquired. In particular, the qMRI maps according to the invention are thus qMRI maps of different tissue properties that can be separately or simultaneously acquired. According to the present invention, each quantitative map, e.g. qMRI map, is thus preferentially a quantitative representation of a single biological or physical characteristic of a tissue of the biological object, "single" meaning notably that a main physical/biological tissue property is quantitatively captured/measured, while other physical/biological tissue properties are absent or negligeable.

A step "B" 202, the processing unit 101 uses for instance a combination algorithm for combining the acquired qMRI maps with each other in order to create the so-called CQM 33. A preferred embodiment of a combination according to the invention is illustrated in Fig. 3, wherein the first qMRI map 31 and the second qMRI map 32 are used as input into the combination algorithm configured for calculating, in the present example, the ratio between the second qMRI map 32 and the first qMRI map 31 (i.e. T2/T1). Said combination, as illustrated in Fig. 3, is preferentially an algebraical operation 34, e.g. a division, a subtraction, an addition, a multiplication, a power, a root, or a combination thereof. In other words, said combination algorithm preferentially comprises one or several algebraic operators. Said combination applies to spatially corresponding voxels of the combined qMRI maps. In particular, a voxel of a qMRI map mapping a physical tissue property spatially is considered as "corresponding" to a voxel of another of said qMRI maps mapping another physical tissue property if their respective values have been obtained by measuring respectively said physical tissue property and said another physical tissue property at the same specific location within or on the biological object.

At step "C" 203, the processing unit 101 calculates a deviation map 35 from the CQM 33 and a normative atlas. In other words, the CQM 33 and the normative atlas are used as inputs to a deviation algorithm configured for outputting said deviation map 35. Preferentially, the deviation map 35 is then displayed on the display 105 of the system 100, or might be used for further processing, e.g. for automatically triggering an acquisition of additional images of the EBO, e.g. additional qMRI maps, wherein said acquisition is only made for each region of the EBO comprising voxels (e.g. comprising a number of voxels greater than a predefined number of voxels) characterized by a deviation in said deviation map that is greater than a predefined threshold.

Preferentially, before calculating said deviation map 35, the system 100 is configured for automatically spatially registering the CQM 33 and the normative atlas, so that the CQM 33 and the normative atlas spatially correspond to each other. This is preferentially performed using known in the art techniques. In particular, if the normative atlas is a region-wise atlas, then the system according to the invention automatically computes a corresponding region-wise CQM for enabling said calculation of the deviation map. Similarly, if the normative atlas is a voxel-wise atlas, then the system according to the invention automatically computes a corresponding voxel-wise CQM for enabling said calculation of the deviation map.

According to the present invention, if a set $M=\{M_1,...,M_n\}$ of qMRI maps are combined for obtaining said CQM, then the intensity or value of each voxel of the deviation map is a function of the difference between

- a value resulting from the combination of the physical tissue properties $(P_1,...,P_n)$ values of the EBO as measured at said voxel-specific location, i.e. for an anatomical region of the biological object, and
- a normative value resulting from the same combination of the values of the same set of physical tissue properties measured for a same anatomical region, but for a group of normative biological objects, e.g. healthy individuals.

The deviation map provides thus a direct view of divergences between measured values (i.e. values experimentally obtained for the EBO) and expected values (i.e. normative values experimentally obtained for "healthy" biological objects) of combined tissue physical properties.

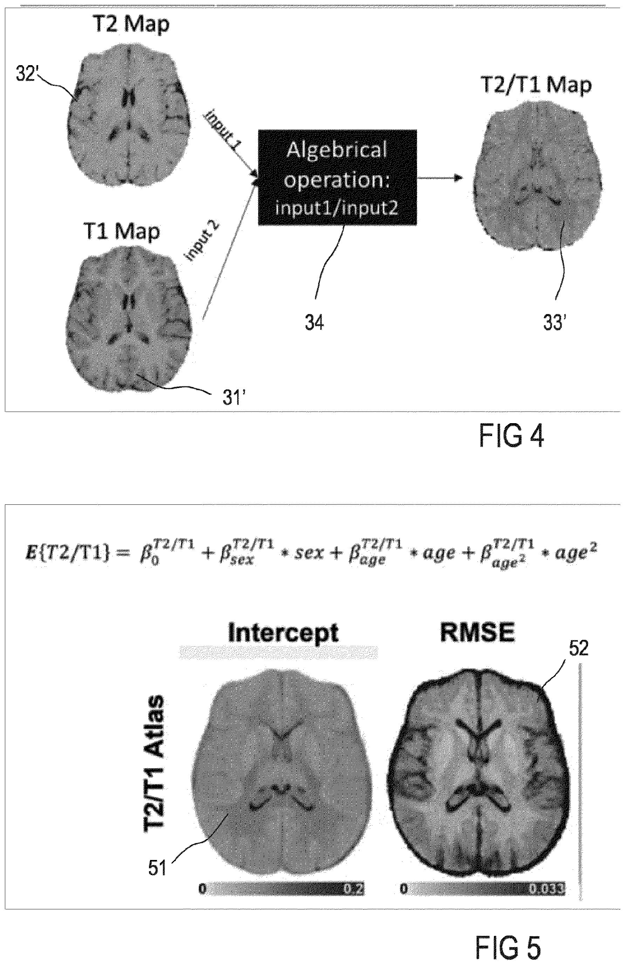

Preferentially, the present invention proposes also to create said normative atlas used for determining deviations of the CQM from normative values. A preferred technique for creating the normative atlas is illustrated by Fig. 4 and 5.

For the creation of the normative atlas, steps A and B are carried out for each normative biological object of a group of normative biological objects. By "normative" it has here to be understood that it refers to biological objects for which the tissue, that is under investigation according to the claimed method, is in a normal/standard state or condition, enabling thus to get standard or normative values when measuring the physical or biological tissue properties of the considered biological object with might serve as reference for comparison with other biological objects. When performing steps A and B for such a normative biological object, the values obtained for the measured physical tissue properties may thus serve as standard, normal values (i.e. reference values), enabling to define ranges of values that characterize the physical properties of a tissue when the latter is in a normal condition or state, and which are usually obtained for a healthy population of said biological objects. Said normative biological objects are thus usually healthy biological objects. The normative biological object comprises thus healthy tissues, in other words, tissues that are free of pathologies (or alterations) and/or tissues whose physical properties or characteristics at a given time T (e.g. at a given age of the biological object) are within said norm or standard known or defined for said healthy population of biological objects when considering the same given time T or age, wherein the physical properties of said healthy tissues are used as a norm for comparison with the physical properties measured for the tissue(s) of the EBO. For instance, if the present invention is used for determining whether a patient organ, e.g. brain, comprises tissue alterations, then said normative biological objects will refer to healthy brains of a healthy cohort. In other words, for each individual of the healthy cohort, the steps A and B will be repeated so as to create for each individual a (normative) CQM of the concerned normative biological object, e.g., the healthy brain. This is notably illustrated in Fig. 4, wherein a first map 31', that is a T1 map, and a second map 32', that is a T2 map, are acquired for each normative biological object (here the brain) of said group, and combined using the same algebraic operation 34 as presented in connection with Fig. 3, in that case a division of the second map 32' by the first map 31', in order to obtain a normative CQM 33' for each normative biological object, in other words for each individual of the group of healthy cohort.

The resulting normative CQMs 33' obtained, for the group of normative biological objects, by using in step B the same combination algorithm that was used for obtaining the CQM for the EBO, can then be used for creating said normative atlas, for instance a voxel-wise atlas or a region-wise atlas. Known in the art techniques might be used for creating said atlases from the acquired CQMs 33'. For instance, the methodology described by Piredda et al. [1] might be mutatis mutandis applied: in this case, a voxel-wise normative atlas is created, wherein voxel-wise estimates of expected values are computed using a linear regression model using as input the obtained normative CQMs 33' and providing as output said (voxel-wise) normative atlas comprising for each voxel the estimated expected value. For region-wise normative atlases, a similar approach can be used by dividing the normative biological object into regions of interest (ROI), e.g. brain regions in the case of the brain, and then estimating for each ROI an expected voxel value from the CQMs 33' voxels comprised within the concerned ROI. An example of voxel-wise normative atlas 51, that is a T2/T1 normative atlas obtained from the normative CQMs 33' of Fig. 4, is provided in Figure 5, together with the resulting RMSE 52. Said normative atlas 51 has been obtained following the methodology of Piredda et al. [1], wherein a regression model including sex, age, and squared age for each individual of a healthy cohort was applied to the normative CQMs, the value E of each voxel of the normative atlas being obtained as follows:

$$E(r) = \beta_0(r) + \beta_{sex}(r) * sex + \beta_{age}(r) * age + \beta_{age2} * age^2$$

wherein

r represents the position of the concerned voxel,
$\beta_0$ is the intercept of the regression model,
$\beta_{sex}$, $\beta_{age}$, $\beta_{age2}$ correspond to predictive coefficients,
sex is a categorical variable equal to 1 if the subject is male or 0 if female, and
age expressed in years (as a whole number) centered at the mean age of the healthy cohort.

Compared to prior art techniques relying on non-quantitative maps (e.g. T1 and/or T2 weighted contrasts), the proposed method and system take advantage of using qMRI maps, hence enabling reliable inter-subject comparisons and allowing to establish normative value ranges/atlases. Additionally, compared to techniques involving the use of a single parametric map, the combination (through transformation/algebraic combination) of multiple qMRI maps as required by the present invention makes it possible to reveal and/or highlight differences from normal (i.e. from expected values) that are not detectable or much less clearly detectable in the single quantitative maps. Furthermore, the CQM provides new quantitative metrics (e.g., the T2/T1 ratio) to characterize normal tissue properties, and may open the way to explore tissue properties that were not yet detected up to now due to the higher sensitivity of the proposed method and system. In particular, the claimed method shows a higher sensitivity compared to an alternative method that would (i) compute a first deviation map for a first qMRI map configured for mapping a first single tissue property and compute a second deviation map for a second qMRI map configured for mapping a second single tissue property (wherein the first and second single tissue properties are different from one another), and then (ii) combine the obtained first and second deviation maps to get a combined deviation map for multiple tissue properties, because the CQM according to the invention is a direct measure of the combination of multiple tissue property values, leading to a more sensitive deviation map compared to the combined deviation map obtained through said alternative method.

Finally, the CQM and the deviation map provide a simultaneous assessment of multiple quantitative tissue properties by combining, each, multiple quantitative tissue properties in a single map. This results in a faster tool for analyzing biological objects compared to an analysis based on separate study of individual quantitative maps of the same quantitative tissue properties.

To conclude, the present invention proposes a system and a method for detecting and quantifying an abnormal state of a tissue, i.e. for detecting and quantifying abnormal values measured for physical properties of said tissue, the concept of the invention being based on the use a combination algorithm for combining qMRI maps of a biological object under examination, said combination algorithm receiving as inputs the qMRI maps and outputting a combined quantitative map. Preferentially, said combination algorithm comprises algebraical operators or other transformations. Advantageously, the created combined quantitative map might better indicate or show physiological effects compared to analyzing separately or individually the qMRI maps used as inputs to the combination algorithm. Furthermore, the present invention proposes to compare the obtained combined quantitative map to a normative atlas preferentially built using a linear regression based on combined quantitative maps obtained from healthy subjects by using the same combination algorithm. Normative values can either be extracted for each voxel, or for an ensemble of voxels (e.g., a specific brain region). Finally, a deviation map is computed by comparing (either voxel-wise or region-wise) voxel values of the combined quantitative map obtained for the biological object under examination to expected voxel values provided by the normative atlas. Preferentially, said deviation map may compute z-scores, defined as the difference between expected and observed values, divided by the RMSE of the linear regression model.

List of citations:

[1] Piredda, Gian Franco, et al. "Quantitative brain relaxation atlases for personalized detection and characterization of brain pathology." Magnetic resonance in medicine 83.1 (2020): 337-351 .

[2] Bonnier, G., et al. "Personalized pathology maps to quantify diffuse and focal brain damage." NeuroImage: Clinical 21 (2019): 101607 .

[3] Vaneckova, M, et al. "Periventricular gradient of T1 tissue alterations in multiple sclerosis." NeuroImage: Clinical 34 (2022): 103009 .

[4] Ravano, V, et al. "T1 abnormalities in atlas-based whire matter tracts: reducing the clinico-radiologicalparadox in multiple sclerosis using qMRI" presented at ISMRM 2021, abstract no. 2796 .

[5] Granziera, Cristina, et al. "Quantitative magnetic resonance imaging towards clinical application in multiple sclerosis." Brain 144.5 (2021): 1296-1311.

[6] Bonnier, Guillaume, et al. "The combined quantification and interpretation of multiple quantitative magnetic resonance imaging metrics enlightens longitudinal changes compatible with brain repair in relapsing-remitting multiple sclerosis patients." Frontiers in neurology 8 (2017): 506.

**Claims**

1. A method for detecting and quantifying an abnormal state of a tissue of a biological object, the method comprising:

   - acquiring (201) multiple quantitative maps of said biological object, wherein each of said multiple quantitative maps is a quantitative map of a different physical tissue property of said biological object;
   - combining (202) the acquired quantitative maps into a "combined quantitative map" (hereafter "CQM");
   - calculating (203) a deviation map by comparing the CQM to a normative atlas configured for providing expected values for the CQM.

2. Method according to claim 1, wherein an algebraic operation is performed on said acquired quantitative maps for combining them with one another.

3. Method according to claim 1 or 2, wherein said combination is performed voxel-wise or region-wise.

4. Method according to one of the claims 1 to 3, wherein said normative atlas is obtained by performing the acquiring (201) and combining (202) steps for each normative biological object of a group of normative biological objects in order to obtain a "normative" CQM for each normative biological object, wherein the normative atlas is then generated by mathematically combining the obtained "normative" CQMs.

5. Method according to one of the claims 1 to 4, wherein the deviation map is computed as a z-score map, wherein a difference between a measured value obtained for a first specific location within the CQM and an expected value obtained for a corresponding specific location within the normative atlas is divided by the root mean square error (RMSE) of residues of a mathematical model used for creating said normative atlas.

6. Method according to one of the claims 1 to 5, wherein the acquired quantitative maps are magnetic resonance imaging quantitative maps (hereafter "qMRI" maps) acquired by a MRI apparatus.

7. Method according to claim 6, wherein said multiple quantitative maps are a T1 qMRI map and a T2 qMRI map.

8. Method according to claim 7, wherein combining the acquired quantitative maps for obtaining the CQM comprises dividing the T2 qMRI map by the T1 qMRI map.

9. System (100) for improved visualization and quantification of an abnormal condition or state of a tissue of a biological object, the system (100) comprising:

   - an interface;
   - a processing unit (101);
   - a memory (102);

   the system (100) being **characterized in that** it is configured for performing the steps of the method according to one of the claims 1 to 8.

10. System (100) according to claim 9, comprising a display (105) for displaying the deviation map.

103    100

T2 Map

101

102

104

105

FIG 1

201 → 202 → 203

FIG 2

32 — T2 Map
T1 Map
31
input 1
input 2
Algebrical operation: input1/input2
34
T2/T1 Map
33
35
z-scores [# rmse]
-10    0    10
36

FIG 3

**FIG 4**

$$E\{T2/T1\} = \beta_0^{T2/T1} + \beta_{sex}^{T2/T1} * sex + \beta_{age}^{T2/T1} * age + \beta_{age^2}^{T2/T1} * age^2$$

**FIG 5**

Europäisches
Patentamt

European
Patent Office

Office européen
des brevets

# EUROPEAN SEARCH REPORT

Application Number

EP 23 16 6468

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | PIREDDA GIAN FRANCO ET AL: "Quantitative brain relaxation atlases for personalized detection and characterization of brain pathology", MAGNETIC RESONANCE IN MEDICINE, vol. 83, no. 1, 16 August 2019 (2019-08-16), pages 337-351, XP093075274, US ISSN: 0740-3194, DOI: 10.1002/mrm.27927 | 1-7,9,10 | INV. G01R33/56 G01R33/44 G01R33/50 |
| A | * page 339 - page 345; figure 1 * | 8 | |
| L | BLYSTAD I. ET AL: "Quantitative MRI for Analysis of Active Multiple Sclerosis Lesions without Gadolinium-Based Contrast Agent", AMERICAN JOURNAL OF NEURORADIOLOGY, vol. 37, no. 1, 13 January 2016 (2016-01-13), pages 94-100, XP093075385, US ISSN: 0195-6108, DOI: 10.3174/ajnr.A4501 * page 95 - page 99 * * This document completes the disclosure of the method/system of document XP093075274, which explicitly makes reference to XP093075385 as reference 10. * | 1-7,9,10 | |
| A | HANNOUN SALEM ET AL: "T1/T2 ratio: A quantitative sensitive marker of brain tissue integrity in multiple sclerosis", JOURNAL OF NEUROIMAGING, vol. 32, no. 2, 9 November 2021 (2021-11-09), pages 328-336, XP093075202, US ISSN: 1051-2284, DOI: 10.1111/jon.12943 * the whole document * | 1-10 | |

TECHNICAL FIELDS
SEARCHED      (IPC)

G01R

The present search report has been drawn up for all claims

| Place of search | Date of completion of the search | Examiner |
|---|---|---|
| Munich | 1 September 2023 | Raguin, Guy |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

        

& : member of the same patent family, corresponding
document

EPO FORM 1503 03.82 (P04C01)

2

**EP 4 443 185 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **PIREDDA, GIAN FRANCO et al.** Quantitative brain relaxation atlases for personalized detection and characterization of brain pathology. *Magnetic resonance in medicine,* 2020, vol. 83 (1), 337-351
- **BONNIER, G. et al.** Personalized pathology maps to quantify diffuse and focal brain damage. *NeuroImage: Clinical,* 2019, vol. 21, 101607
- **VANECKOVA, M et al.** Periventricular gradient of T1 tissue alterations in multiple sclerosis. *NeuroImage: Clinical,* 2022, vol. 34, 103009
- **RAVANO, V et al.** T1 abnormalities in atlas-based whire matter tracts: reducing the clinico-radiologicalparadox in multiple sclerosis using qMRI. *presented at ISMRM,* 2021
- **GRANZIERA, CRISTINA et al.** Quantitative magnetic resonance imaging towards clinical application in multiple sclerosis. *Brain,* 2021, vol. 144 (5), 1296-1311
- **BONNIER, GUILLAUME et al.** The combined quantification and interpretation of multiple quantitative magnetic resonance imaging metrics enlightens longitudinal changes compatible with brain repair in relapsing-remitting multiple sclerosis patients. *Frontiers in neurology,* 2017, vol. 8, 506